Europäisches Patentamt

(19) European Patent Office

Office européen des brevets

(11) Publication number : **0 462 698 A2**

## (12) EUROPEAN PATENT APPLICATION

(21) Application number : 91304208.1

(22) Date of filing : 10.05.91

(51) Int. Cl.⁵ : **G03F 1/14**

(30) Priority : 18.05.90 GB 9011165

(43) Date of publication of application :
27.12.91 Bulletin 91/52

(84) Designated Contracting States :
CH DE FR GB IT LI NL

(71) Applicant : HOLTRONIC TECHNOLOGIES
LIMITED
Rolls House 7 Rolls Buildings Fetter Lane
London EC4A 1NH (GB)

(72) Inventor : Brook, John Edward
Chemarin, 1
CH-2523 Lignieres (CH)
Inventor : Clube, Francis Stace Murray
Edmond de Reynier, 8
CH-2000 Neuchatel (CH)

(74) Representative : Paget, Hugh Charles Edward
et al
MEWBURN ELLIS & CO. 2/3 Cursitor Street
London EC4A 1BQ (GB)

(54) Masks for high quality images from total internal reflection holograms.

(57) In order to reduce or eliminate undesired fringe patterns occurring in images generated by total internal reflection holograms, the mask (20) is provided with an anti-reflection coating (19) on at least one of its underside surface (26) and top surface (16). An anti-reflection coating (19) provided on the underside surface (26) of the mask (20) may also increase the depth of focus of images generated by total internal reflection holograms.

Fig. 4

The present invention relates to the recording of a total internal reflection (TIR) hologram, and more particularly relates to the recording of holographic masks, for use in the creation of high definition holographic images for applications such as integrated circuit manufacturing.

It has been proposed to utilize a TIR holographic technique to create an image of a mask, for example in connection with the fabrication of an integrated circuit. In this connection reference should be made to European Patent Specification 0251681 and U.S. Patent Specification 4857425.

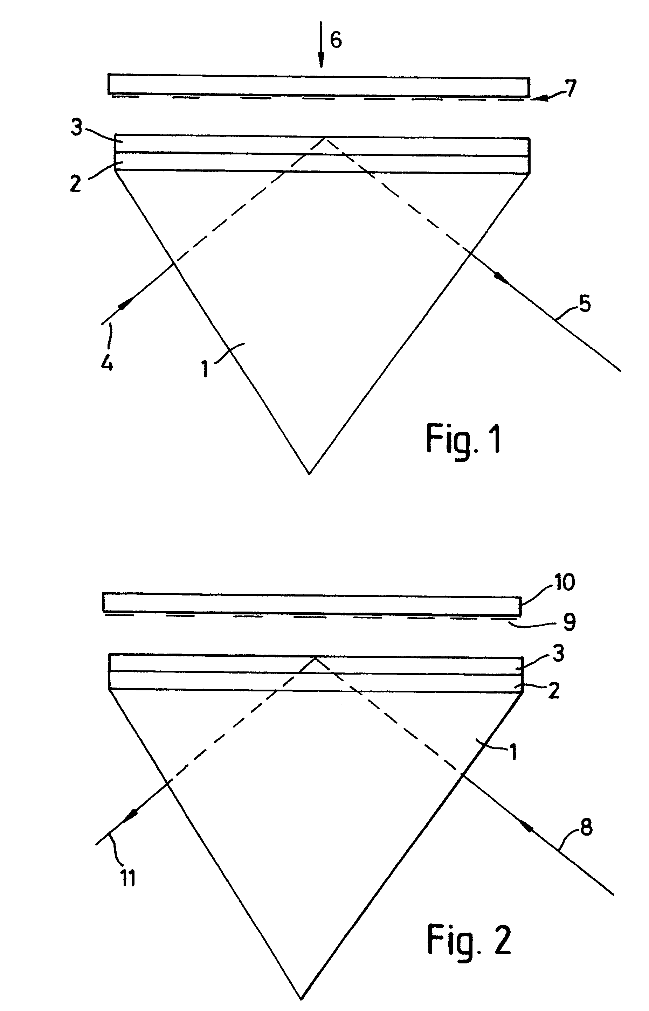

Referring to Fig. 1 of the accompanying drawings, these prior Specifications disclose a technique for making a mask utilizing holographic techniques in which a glass prism 1 is utilized, to one face of which is adhered, by means of a fluid having substantially the same refractive index as that of glass, a glass slide 2 which carries a coating 3 of an optically sensitive photopolymer material.

The photopolymer material is such that when exposed to light and developed appropriately the refractive index of the photopolymer is altered in accordance with the amount of exposure to actinic radiation.

In these prior Specifications there is disclosed a method of creating a holographic record of an image, comprising the steps of applying to the face of a prism a transparent planar substrate carrying a film of photosensitive material, directing into the prism a reference beam of coherent light and causing the beam of light to be totally internally reflected from the surface of the photosensitive layer, directing to the photosensitive layer a signal beam passing through means to provide an image to be recorded in the photosensitive layer, developing the photosensitive layer, again locating the substrate and the photosensitive layer on the said face of the prism and shining coherent light into the prism along a path substantially aligned with the path by which the internally reflected coherent light left the prism during the creation of the holographic record, this re-creating, holographically, the image.

In order to record a holographic image within the photopolymer the prism and the glass slide are positioned as illustrated in Figure 1, with the glass slide on the horizontal upper surface of the prism, and a reference beam 4 of coherent light, such as laser light, is directed into the prism through one face, in such a direction that the beam passes into the glass slide 2, into the layer of photopolymer, and is totally internally reflected from the upper surface of the layer of photopolymer, the beam then re-entering the glass slide, subsequently re-entering the prism and leaving the prism as a reflected beam 5.

A signal beam 6, again of coherent light, is caused to pass through a mask 7 presenting transparent areas and opaque areas, and the beam, having passed through the mask 7, also enters the photopolymer layer 3, where the beam which has passed through the mask 7 interferes with the reference beam 4. The signal beam actually interferes with the reference beam partly before it is totally internally reflected, and partly after it is totally internally reflected. An interference pattern is thus created, and the photopolymer is polymerized in areas where the interference pattern represents a relatively high intensity of light and is polymerized substantially less in regions where the interference pattern represents a relatively low intensity of light.

After the photopolymer has been developed, a hologram has been recorded within the photopolymer as regions of different refractive index. This hologram may be replayed by again utilizing the prism 1 to which is attached the slide 2 carrying the now developed photopolymer layer 3.

As shown in Figure 2 of the accompanying drawings the slide is again located on the upper surface of the prism. A replay beam 8 of coherent light is provided which is directed into the prism 1 substantially along the path along which the reflected beam 5 left the prism during the creation of the hologram as described above, so that the replay beam is totally internally reflected at the upper surface of the photopolymer layer 3. The result of this is that an image 9 is created corresponding to the form of the mask 7. The image 9 may be created on the surface of a silicon wafer 10 which has been coated with a photo-resist, and which is positioned appropriately. Thus the photoresist will be exposed in areas corresponding to the transparent areas of the mask 7. After appropriate development, areas of the photoresist, such as the exposed areas, may be washed away, the remaining areas of photoresist on the wafer 10 corresponding to the mask pattern.

Utilizing this technique it is possible to generate a very fine mask on a substrate 10, such as silicon wafer. However, the technique does possess certain limitations.

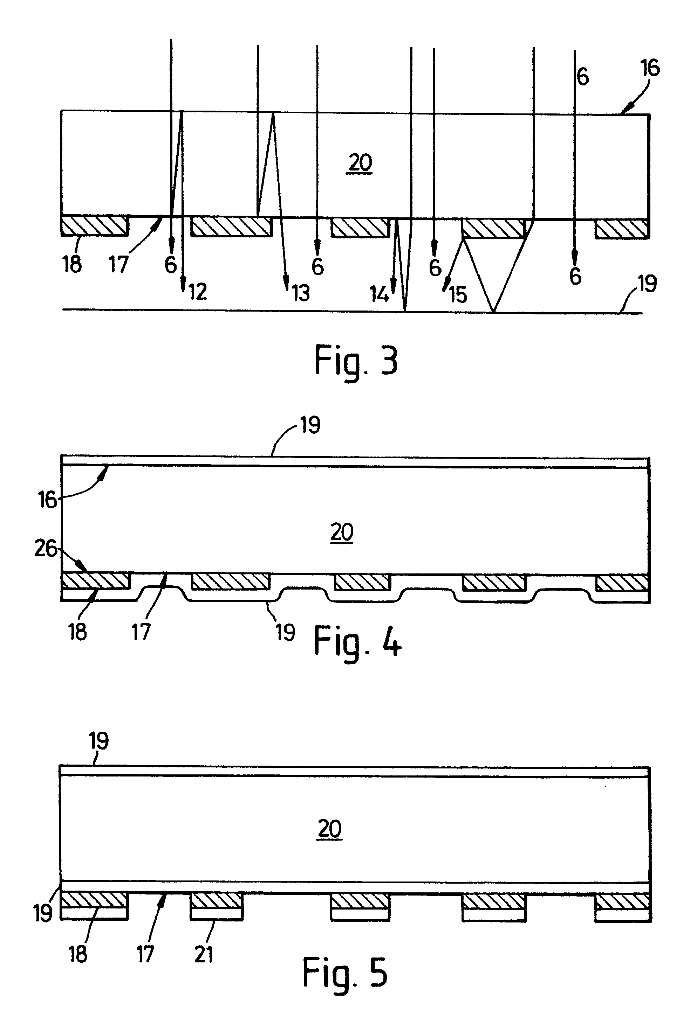

Figure 3 of the accompanying drawings illustrates the optical path of the signal beam 6 during the construction of a hologram using the prior art technique.

It will be understood that in order to have high quality, uniform structures in the holographic image 9 it is necessary that the uniformity of the light intensity in the transparent areas of the original mask 7 is very good, otherwise there will be uneven etching of the photoresist coated wafer 10 during printing.

It has been discovered that in using the prior art technique discussed above, despite having a high uniformity of signal beam 6 entering the mask 7 the resulting holographic image has non-uniform intensity in the areas corresponding to the transparent areas 17 of the mask. It has been further discovered that these non-uniformities have the form of structured fringing and that this structured fringing consists of two components. The first of these is a fine essentially cross-hatched pattern superimposed across the complete mask image, the position of this pattern apparently bearing no relation to the positions of the features in the image, but its orientation corresponding to the directionality of the features. The second component in the fringe pattern is feature dependent, in that the shapes, positions and orientations of particular fringes are related to the local feature structure. For instance, the fringe pattern lying within particular sizes of square features takes the form of a cross, whilst within long strips it consists of a set of fringes lying parallel to the strip, the separation of successive fringes varying but being symmetrically disposed across the strip. It has been determined that the cause of the first component is that during recording of the hologram a proportion of the signal beam 6 incident on the mask plane is reflected from the features, and this diffracting lightfield, containing high angular components, is then partially reflected from the upper surface 16 of the mask substrate 20 whence it returns to the mask plane. This spurious beam then interferes with the main signal beam and, because of the coherent nature of the light source, produces an unacceptably high contrast cross-hatched interference pattern, subsequently observed as fringing in the mask image at reconstruction. The cause of the second component has again been discovered to arise during hologram formation. In this case, the signal beam 6 transmitted by apertures in the mask is partially reflected from the surface 19 of the photopolymer layer and returns to the apertures 17 whereupon it is partially reflected back to the holographic layer. This spurious beam which has undergone Fresnel diffraction, then interferes with the primary signal beam and, because of the coherence of the light source, leads to the unacceptably high contrast feature-related fringing observed in the reconstructed image. Figure 3 shows the paths of various spurious beams 12-15 set up by multiple reflections.

The coherent interference of spurious beam 12 with beam 6 and of spurious beam 13 with beam 6 results in the fine, cross-hatched fringe pattern, whilst the coherent interference of spurious beam 14 with beam 6 results in the feature-related pattern.

It will be further understood that in order that a good, sharp image be recorded through the thickness of the photo-sensitive layer during replay and that this pertains across the complete wafer area, whose surface may not be especially flat, it is necessary that the reconstructed mask image has a good depth of focus.

It has been discovered using the prior art technique discussed above that the depth of focus of features in the reconstructed image is not as large as one would expect from conventional imaging theory alone. For only small displacements away from the image plane, the edges of imaged features rapidly lose their acuity, becoming "woolly". It has further been discovered that a cause of this reduction in the depth of focus arises from multiple reflections of the signal beam after it has been passed through the mask, that take place between the surface of the photopolymer layer 19 and the edges of the opaque, usually chrome, areas 18 of the mask. These spurious beams then, except in the plane of the mask itself, interfere coherently with the main signal beam, degrading the depth of focus. Again referring to Figure 3, coherent interference between spurious beam 15 and signal beam 6 reduces the depth of focus of the reconstructed image.

In addition to the known art referred to above the following disclosures should be noted in passing.

British Patent Specification 2,128,365 (Western Electric) which discloses a photo-mask, which is used to form patterns on a resist-coated semi-conductor wafer. The layers which make up the photo-mask are only for reducing static in the mask. It should be noted that the reference to "reflection" is limited only to the use of an antistatic layer with a compatible index to that of the underlying layers.

British Patent Specification 1,332,702 (A.R.Diem) also relates to a silicon photo-mask, but has no anti-reflection coatings.

European Patent Specification 0, 203, 563 (Asaki Glass Company Ltd) relates to a process of reducing the reflection of the chrome only in a chrome mask by the addition of oxygen during the chrome deposition process to "blacken" the chrome leading to a lower reflectance. There is no reference to the use of anti-reflection techniques for the transparent areas of the mask or the rear side thereof.

British Patent Specification 2,040,498 (Hitachi, Ltd.) refers to the minimizing of reflections from a lithographic substrate and not from a photo-mask.

Finally, it should be noted that the disclosure in our prior United States Patent Specification 4,857,425 refers only to holographic materials and not a photo-mask. Furthermore as noted above, it relates to the problems of scattering and not to the problems of unwanted reflections.

The present invention seeks to provide an improved process in which one or more of the disadvantages of the prior art are obviated or reduced.

According to one aspect of the present invention there is provided a method of constructing a TIR hologram, including: providing an anti-reflection coating on at least one of an underside surface and a top surface of a mask, the mask containing transparent and opaque areas to provide an image to be recorded in a holographic recording layer; and directing to the holographic recording layer a signal beam passing through the mask and also a reference beam totally internally reflected from a surface of the holographic recording layer; wherein the anti-reflection coating or coatings obviate or minimize the occurrence of fringe patterns degrading the uniformity of the intensity of the image in the areas corresponding to the transparent areas of the mask during reconstruction of the image from the hologram.

According to a second aspect of the present invention there is provided a method of constructing a TIR hologram, including: providing an anti-reflection coating on an underside surface of a mask, the mask containing transparent and opaque areas on its underside surface to provide an image to be recorded in a holographic recording layer; and directing to the holographic recording layer a signal beam passing through the mask and also a reference beam totally internally reflected from a surface of the holographic recording layer; wherein the anti-reflection coating obviates or minimizes the occurrence of fringe patterns degrading the uniformity of the intensity of the image in the areas corresponding to the transparent areas of the mask during reconstruction of the image from the hologram and increases the depth of focus of the image reconstructed from the hologram.

According to a third aspect of the present invention there is provided a mask for use in the construction of a TIR hologram, the mask containing transparent and opaque areas to provide an image to be recorded in a holographic recording layer by directing to the holographic recording layer a signal beam passing through the mask and also a reference beam totally internally reflected from a surface of the holographic recording layer; wherein an anti-reflection coating is provided on at least one of an underside surface and a top surface of the mask.

The or each anti-reflection coating may be applied to its respective surface of the mask before the transparent and opaque areas of the mask are created.

As used herein, the terms "underside surface" and "top surface" mean the surfaces of the mask at which the signal beam respectively exits from and enters the mask, and do not infer any limitation on the orientation of the mask used in the methods of the invention.

Preferred embodiments of the present invention will now be described in detail, by way of example only, with reference to the accompanying drawings, in which:

Figure 1 is a diagrammatic view of a known technique for making a mask utilizing holographic techniques;

Figure 2 is a diagrammatic view is a further step in the known technique where a replay operation causes the hologram to be transferred to a recording medium on a silicon wafer;

Figure 3 is a diagram illustrating the optical path of the signal beam during the reconstruction of a hologram utilizing the prior art technique;

Figure 4 is a diagrammatic view illustrating a preferred form of photomask in accordance with the present invention to remove multiple reflections; and

Figure 5 is a diagrammatic view of an alternative form of photomask.

Referring to Figure 4, the procedures utilized are very similar to the procedures described above with reference to Figures 1, 2 and 3 and thus the same reference numerals will be used for the same features. In carrying out the method, instead of using a standard photomask, as in the prior art, the substrate 20 of the photomask is specially treated by having its top surface 16 and its underside surface 26 coated with anti-reflection coatings 19.

The anti-reflection coating should preferably be specified to have its minimum reflection (for example 0.5%) at the wavelength of the signal beam 6 for both the substrate material/air interface and the air/opaque areas interface. Furthermore, the anti-reflection coating should preferably have low reflectance (for example 0.5%) over for example +/- 40, as the unwanted multiple reflected beams 12, 13, 14 and 15 of the type as shown in Figure 3 will be diffracted over a range of angles due to the size of the features on the photomask, which can be comparable to the wavelength of the light used.

Using this new procedure the photomask constructed in accordance with the present invention as shown in the embodiment of Figure 4, is able to improve the quality of the reconstructed holographic image as follows, the reference number referring to the type of reflections being shown in Figure 3:--

(a) the fine cross-hatched fringe pattern is removed by the coating on surface 16, via the minimization of multiple reflections 12 and 13;

(b) the feature-related fringe patterns are removed by the coating on transparent areas 17, via the minimization of multiple reflection 14;

(c) the depth of focus of the reconstructed image is improved by the coating on opaque areas 18, via the minimization of multiple reflection 15.

Referring now to the alternative preferred form shown in Figure 5, the anti-reflection coatings 19 are put onto the substrate 20 before the material to form the opaque areas 18 of the mask is applied. Following the deposition of the opaque layer, a further anti-reflection coating 21 is applied to the layer. The transparent areas 17 in the mask are then created. This procedure has the same effect of either eliminating or minimizing the unwanted fringe patterns in the reconstructed image and improving the depth of focus of said image via the minimization of reflections (12-15) referred to in Figure 3 in precisely the same manner as in the construction shown in Figure 4.

This invention can be applied equally to all applications where photomasks are illuminated by coherent light.

## Claims

1. A method of constructing a TIR hologram, including: providing a mask containing transparent and opaque areas to provide an image to be recorded in a holographic recording layer; and directing to said holographic recording layer a signal beam passing through the mask and also a reference beam totally internally reflected from a surface of said holographic recording layer; characterized by providing an anti-reflection coating on at least one of an underside surface and a top surface of the mask, wherein said anti-reflection coating or coatings obviate or minimize the occurrence of fringe patterns degrading the uniformity of the intensity of the image in the areas corresponding to the transparent areas of the mask during reconstruction of the image from said hologram.

2. A method of constructing a TIR hologram and reconstructing an image from said hologram, including: providing a mask containing transparent and opaque areas to provide an image to be recorded in a holographic recording layer; directing to said holographic recording layer a signal beam passing through the mask and also a reference beam totally internally reflected from a surface of said holographic recording layer; developing the hologram thus formed; and reilluminating the hologram with coherent light in a direction substantially opposite to the path by which the totally internally reflected beam left the holographic recording layer during the construction of the hologram, in order to provide a reconstructed image of the mask; characterized by providing an anti-reflection coating on at least one of an underside surface and a top surface of the mask, wherein said anti-reflection coating or coatings obviate or minimize the occurrence of fringe patterns degrading the uniformity of the intensity of the image in the areas corresponding to the transparent areas of the mask during reconstruction of the image from said hologram.

3. A method according to claim 2, wherein the image reconstructed from the hologram is recorded in a photosensitive layer.

4. A method according to any one of claims 1 to 3, wherein the or each anti-reflection coating is applied to its respective surface of the mask before the transparent and opaque areas of the mask are created.

5. A method of constructing a TIR hologram, including: providing a mask containing transparent and opaque areas on its underside surface to provide an image to be recorded in a holographic recording layer; and directing to said holographic recording layer a signal beam passing through the mask and also a reference beam totally internally reflected from a surface of said holographic recording layer; characterized by providing an anti-reflection coating on said underside surface of the mask, wherein said anti-reflection coating obviates or minimizes the occurrence of fringe patterns degrading the uniformity of the intensity of the image in the areas corresponding to the transparent areas of the mask during reconstruction of the image from said hologram and increases the depth of focus of the image reconstructed from said hologram.

6. A method of constructing a TIR hologram and reconstructing an image from said hologram, including: providing a mask containing transparent and opaque areas on its underside surface to provide an image to be recorded in a holographic recording layer; directing to said holographic recording layer a signal beam passing through the mask and also a reference beam totally internally reflected from a surface of said holographic recording layer; developing the hologram thus formed; and reilluminating the hologram with coherent light in a direction substantially opposite to the path by which the totally internally reflected beam left the holographic recording layer during the construction of the hologram, in order to provide a reconstructed image of the mask; characterized by providing an anti-reflection coating on said underside surface of the mask, wherein said anti-reflection coating obviates or minimizes the occurrence of fringe patterns degrading the uniformity of the intensity of the image in the areas corresponding to the transparent areas of the mask during reconstruction of the image from said hologram and increases the depth of focus of the reconstructed image.

7. A method according to claim 6, wherein the image reconstructed from the hologram is recorded in a photosensitive layer.

8. A method according to any one of claims 5 to 7, wherein the anti-reflection coating is applied to the surface of the mask before the transparent and opaque areas of the mask are created.

9. A mask for use in the construction of a TIR hologram, the mask containing transparent and opaque areas to provide an image to be recorded in a holographic recording layer by directing to said holographic recording layer a signal beam passing through the mask and also a reference beam totally internally reflected from a surface of said holographic recording layer; characterized in that an anti-reflection coating is provided on at least one of an underside surface and a top surface of the mask.

10. A mask according to claim 9, wherein the or each anti-reflection coating is applied to its respective surface of the mask before the transparent and opaque areas of the mask are created.

Fig. 1

Fig. 2

Fig. 3

Fig. 4

Fig. 5